# EUROPEAN PATENT APPLICATION

(11) **EP 3 021 127 A1**
(43) Date of publication of application: **18.05.2016**
(21) Application number: 14823079.0
(22) Date of filing: 27.06.2014
(51) Int. Cl.: G01R 31/36, H01M 10/48, H02J 7/00

(54) **METHOD FOR ESTIMATING STATE OF ELECTRICITY STORAGE DEVICE**

(30) Priority: 10.07.2013 JP 2013144591
(71) Applicant: Alps Green Devices Co., Ltd., Ota-ku, Tokyo 145-8501 (JP)
(72) Inventor: HEBIGUCHI, Hiroyuki, Tokyo 145-8501 (JP)
(74) Representative: Klunker . Schmitt-Nilson . Hirsch
(86) International application number: PCT/JP2014/067171
(87) International publication number: WO 2015/005141

(57) **Abstract**

To provide an electricity storage device state inference method by which a state of an electricity storage device can be accurately inferred by a simple method in which measurement of temperature is not performed. [Solution] The internal impedance |Z| of an electricity storage device 10 is measured at a frequency at which the internal impedance of the electricity storage device 101 does not change with temperature, and the SOC or SOH of the electricity storage device 101 is inferred on the basis of the measured value. Furthermore, the real part R of the internal impedance of the electricity storage device 10 is measured at a frequency at which the real part R of the internal impedance of the electricity storage device 101 does not change with temperature, and the SOC or SOH of the electricity storage device 101 is inferred on the basis of the measured value.

## Description

### INFERENCE METHOD

### Technical Field

The present invention relates to a method of inferring a state of an electricity storage device, and more particularly to a method of inferring the deterioration state or charged state of an electricity storage device with a simple structure.

### Background Art

Electricity storage devices such as lithium-ion batteries and electric double-layer capacitors are used in various applications such as mobile telephones and automobiles. In a case in which an electricity storage device is used as an electric power supply source, it is necessary to correctly grasp the amount of remaining electricity and a deterioration state. In the case of an electric car, for example, information about the amount of remaining electricity of the battery is necessary to avoid a situation as in which an operation becomes impossible at an unpredictable place. In the determination of a time at which to replace the battery and in charging and discharging control performed to prolong the battery life, information about the deterioration state of the battery is necessary.

To infer the charged state (SOC: state of charge) or deterioration state (SOH: state of health) of an electricity storage device, various methods have been conventionally proposed. In PTL 1 described below, a method is described in which a ratio between the internal resistance, measured in a predetermined state (for example, a fully charged state), of a secondary battery and the internal resistance measured in an arbitrary state is obtained and a relative SOC (ratio between a remaining capacity and a fully charged capacity) corresponding to this internal resistance ratio is obtained on the basis of a data table obtained in a preliminary measurement. A method of obtaining an SOH on a basis of a ratio between a change in the relative SOC and the amount of integrated current is also described in PTL 1. Since the internal resistance of the secondary battery changes with temperature, in the method described in PTL 1, processing to correct the internal resistance according to the measurement result of the temperature of the secondary battery is performed.

On the other hand, in PTL 2 described below, a method is described in which successive electric power losses of an electricity storage device are measured and the terminal temperature of the electricity storage device is also measured, after which a difference in temperature between the terminal of the electricity storage device and its center is obtained on the basis of the thermal resistance of the electricity storage device from the center to the terminal and the successive electric power losses, and a temperature at the center of the electricity storage device is detected by adding the difference in temperature to the measured value of the terminal temperature.

### Citation List

### Patent Literature

PTL 1: Japanese Unexamined Patent Application Publication No. 2012-189373
PTL 2: Japanese Unexamined Patent Application Publication No. 2011-232083

### Summary of Invention

### Technical Problem

Methods of inferring an SOH or SOC on a basis of the internal resistance of an electricity storage device or the like, such as the method described in PTL1, have been conventionally known. In general, the internal resistance (direct-current resistance, alternating-current resistance) of an electricity storage device changes with temperature and a relationship between the SOH or SOC and the internal resistance also changes with temperature. Unless temperature is considered together with the internal resistance, a correct SOH or SOC cannot be inferred. In a conventional method in which an SOH or SOC is inferred on a basis of the internal resistance and the like, therefore, the temperature of the electricity storage device also needs to be measured. However, it is complex and difficult to accurately measure the temperature of the electricity storage device, as described in PTL 2, so there is the problem that the device structure and data processing become complex.

The present invention addresses the above situation and its purpose is to provide an electricity storage device state inference method by which a state of an electricity storage device can be accurately inferred by a simple method in which measurement of temperature is not performed.

### Solution to Problem

The electricity storage device state inference method of the present invention is characterized in that: at least one frequency at which the internal impedance of an electricity storage device does not change with temperature, the internal impedance is measured or, at least one frequency at which the real part of the internal temperature does not change with temperature, the real part is measured; and the SOC (state of charge) or SOH (state of health) of the electricity storage device is inferred on the basis of the measured value of the internal impedance or the measured value of the real part.

Preferably, the frequency at which the internal impedance is measured is a frequency at which a change of a component in the internal impedance, the component being based on ion conduction, with temperature and a change of a component in the internal impedance, the component being based on electron conduction, with temperature are offset by each other.

Preferably, the frequency at which the real part is measured is a frequency at which a change of a component in the real part, the component being based on ion conduction, with temperature and a change of a component in the real part, the component being based on electron conduction, with temperature are offset by each other.

In the electricity storage device state inference method described above, the SOC or SOH of the electricity storage device is inferred on the basis of the measured value of the internal impedance at the frequency at which the internal impedance does not change with temperature or the measured value of the real part at the frequency at which the real part of the internal impedance does not change with temperature. Since a state of the electricity storage device is measured on the basis of the measured value of the internal impedance or real part that does not depend on the temperature, the temperature measurement of the electricity storage device becomes unnecessary.

In the electricity storage device state inference method described above, there may be a plurality of frequencies at which the internal impedance does not change with temperature or a plurality of frequencies at which the real part does not change with temperature. In this case, the measurement may be performed at the frequency at which the frequency-depending change rate of the amount of change of the internal impedance or real part of a target under measurement with temperature is smallest among the plurality of frequencies or at the frequency at which the frequency-depending change rate of the amount of change of the internal impedance or real part of the target under measurement with the SOC is smallest among the plurality of frequencies.

Thus, it is possible to suppress inference precision from being lowered due to an influence such as small measurement error or individual-depending variations in frequency characteristics.

Alternatively, in a case in which there are a plurality of frequencies at which the internal impedance does not change with temperature or there are a plurality of frequencies at which the real part does not change with temperature, the measurement of the internal impedance or real part may be performed at the plurality of frequencies and the inference of the SOC or SOH may be performed on the basis of the measured values of the internal impedance or real part at the plurality of frequencies. Then, the average of a plurality of results of the inference on the basis of the plurality of frequencies may be calculated.

Thus, the possibility that due to an influence such as measurement error or individual-depending variations in frequency characteristics, large error occurs in the inference result is reduced.

In the above electricity storage device state inference method, the electricity storage device may be a lithium-ion battery. In this case, the measurement of the internal impedance may be performed at a frequency of 4 kHz and/or 500 kHz. If the electricity storage device is a lithium-ion battery, the measurement of the real part may be performed at a frequency of 10 kHz and/or 4 MHz.

In the above electricity storage device state inference method, the frequency response characteristics of the internal impedance or real part in a predetermined frequency range may be repeatedly measured a plurality of times in a predetermined temperature changing period during which the temperature of the electricity storage device changes in a state in which the charging and discharging of the electricity storage device are being stopped. A frequency corresponding to the intersection of a plurality of frequency response curves indicated by a plurality of measurement results of the frequency response characteristics may be obtained as the frequency at which the internal impedance or real part does not change with temperature.

Thus, even in a case in which the characteristics vary for each electricity storage device, an appropriate frequency can be obtained for each individual as the frequency at which the internal impedance or real part does not change with temperature.

In the above electricity storage device state inference method, of the measured values of the internal impedance or real part, the measured values being included in the measurement results of the frequency characteristics, a measured value at the frequency closest to the frequency corresponding to the intersection may be obtained as a measured value to be used in the inference of the SOC or SOH of the electricity storage device.

Thus, since a measured value to be used in the inference of a state of the electricity storage device is obtained from the already-obtained measured values, the number of measurements is reduced when compared with a method in which a frequency at which the internal impedance or real part does not change with temperature is obtained and the internal impedance or real part is then further measured at that frequency.

The temperature changing period may be, for example, a period immediately after the charging or discharging of the electricity storage device is terminated.

In the measurement of the frequency response characteristics, while the frequency of an alternating-current signal to be supplied to the electricity storage device is changed from low frequency to high frequency or from high frequency to low frequency in the predetermined frequency range, the internal impedance or real part may be measured at a plurality of frequencies included in the frequency range.

### Advantageous Effects of Invention

According to the present invention, a state of an electricity storage device can be accurately inferred by a simple method in which measurement of temperature is not performed.

### Brief Description of Drawings

[Fig. 1] Fig. 1 is a drawing that illustrates an example of the structure of an electricity storage device state inference system according to a first embodiment of the present invention;
[Fig. 2] Fig. 2 is a drawing that illustrates an example of an electricity storage device, schematically representing the structure of a lithium-ion secondary battery;
[Fig. 3] Fig. 3 is a drawing that illustrates that the temperature dependency of the internal impedance of the electricity storage device changes with frequency;
[Fig. 4] Fig. 4 is a drawing that illustrates that the SOC dependency of the internal impedance of the electricity storage device changes with frequency;
[Fig. 5] Fig. 5 is a drawing that illustrates a ratio between the SOC dependency illustrated in Fig. 4 and the temperature dependency illustrated in Fig. 3;
[Fig. 6] Fig. 6 is a drawing that illustrates that the temperature dependency of the real part of the internal impedance of the electricity storage device changes with frequency;
[Fig. 7] Fig. 7 is a drawing that illustrates that the SOC dependency of the real part of the internal impedance of the electricity storage device changes with frequency;
[Fig. 8] Fig. 8 is a drawing that illustrates a ratio between the SOC dependency illustrated in Fig. 7 and the temperature dependency illustrated in Fig. 6;
[Fig. 9] Fig. 9 is a drawing that illustrates an example of a procedure for obtaining an inferred value in an electricity storage device state inference system according to a second embodiment of the present invention;
[Fig. 10] Fig. 10 is a drawing that illustrates that the frequency characteristics of the internal impedance of the electricity storage device or the real part of the internal impedance change with temperature;
[Fig. 11] Fig. 11 is a drawing that illustrates an example of a procedure for obtaining an inferred value in an electricity storage device state inference system according to a third embodiment of the present invention;
[Fig. 12] Fig. 12 is a drawing that illustrates another example of a procedure for obtaining an inferred value in the electricity storage device state inference system according to the third embodiment of the present invention;
[Fig. 13] Fig. 13 is a drawing that illustrates an example of a modification of an electricity storage device state inference system; and
[Fig. 14] Fig. 14 is a drawing that illustrates an example of another modification of an electricity storage device state inference system.

### Description of Embodiments

### <First embodiment>

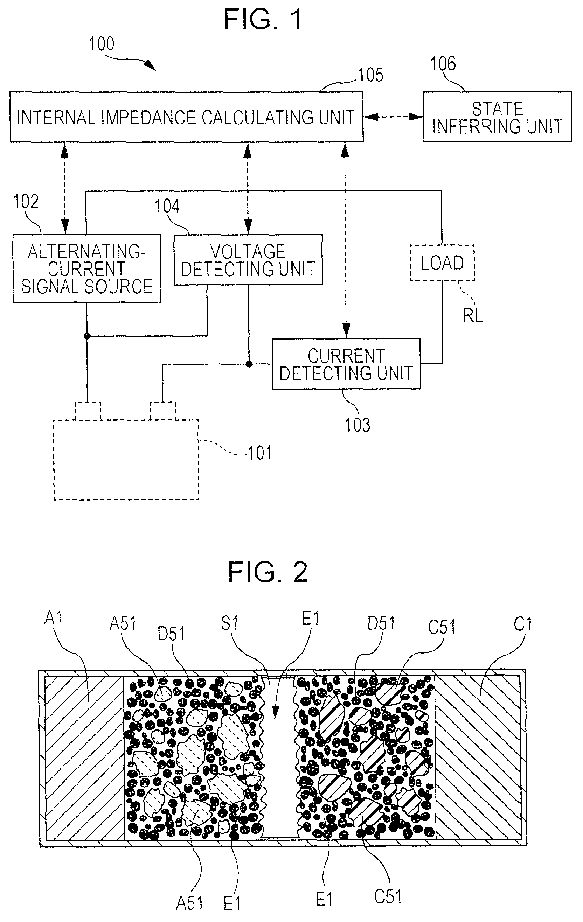

Fig. 1 is a drawing that illustrates an example of the structure of an electricity storage device state inference system 100 according to a first embodiment of the present invention. The system 100 illustrated in Fig. 1 includes an alternating-current signal source 102 that supplies an alternating-current signal to an electricity storage device 101, a current detecting unit 103 that detects a current that will flow in the electricity storage device 101, a voltage detecting unit 104 that detects a voltage to be applied to the electricity storage device 101, an internal impedance calculating unit 105 that calculates the internal impedance of the electricity storage device 101 on the basis of the detected current and voltage, and a state inferring unit 106 that infers a state (SOC, SOH) of the electricity storage device 101 on the basis of the calculation result of the internal impedance calculating unit 105.

The electricity storage device 101 is structured by including, for example, a chargeable chemical battery, such a lithium secondary battery, or a device, such as an electric double-layer capacitor, that stores electric energy by using ions.

Fig. 2 is a drawing that schematically represents the structure of a lithium-ion secondary battery as an example of the electricity storage device 101. The electricity storage device 101 includes an anode collector A1, a cathode collector C1, an electrolyte E1, and a separator S1 as general constituent elements. Besides the constituent elements described above, the electricity storage device 101 includes, for example, an anode active material A51, which is a material that stores electricity present on the same side as the anode collector A1, a cathode active material C51, which is a material that stores electricity present on the same side as the cathode collector C1, a conduction supporting agent D51, which is added to improve the flow of electricity, a biding material, which is a binder, and the like, as the lithium-ion secondary battery.

As for the lithium-ion secondary battery, aluminum (Al) is generally used as the anode collector A1, copper (Cu) is generally used as the cathode collector C1, a solution of an organic solvent (such as C₄H₆O₃) and a solute of lithium salt (such as LiPF₆) is generally used as the electrolyte E1, lithium cobaltate (such as LiCoO₂) is generally used as the anode active material A51, and carbon (C) is generally used as the cathode active material C51. Lithium nickel oxide (LiNiO₂), lithium manganese oxide (LiMn₂O₄), olivine-type lithium iron phosphate (LiFePO₄) or the like may be used as the anode active material A51. Graphite crystals formed like a layer are used as carbon (C) in the cathode active material C51; a feature is that lithium is stored between layers in the state of ions. Lithium titanate (Li₄Ti₅O₁₂), silicon monoxide (SiO), a Sn alloy, a Si alloy or the like may be used as the cathode active material C51.

The alternating-current signal source 102 is a circuit for generating an alternating-current signal used to measure the internal impedance of the electricity storage device 101. In the example in Fig. 1, the alternating-current signal source 102 is disposed on a path of a current that flows from the electricity storage device 101 to a load RL. For example, the alternating-current signal source 102 generates an alternating-current signal having an amplitude and a frequency that correspond to a control signal from the internal impedance calculating unit 105 and supplies the generated alternating-current signal to the electricity storage device 101. The frequency of the alternating-current signal generated by the alternating-current signal source 102 is set to a frequency at which the internal impedance of the electricity storage device 101 or the real part of the internal impedance does not change with temperature (at which the temperature coefficient becomes zero). This frequency will be described later in detail.

The current detecting unit 103 is a circuit that detects a current that flows from the electricity storage device 101. The current detecting unit 103 is disposed on a path of a current that flows from the electricity storage device 101 to the load RL. The current detecting unit 103 includes, for example, a current sensor, such as a magnetoresistive element, and a signal processing circuit that processes an output signal of the current sensor.

The voltage detecting unit 104 is a circuit that detects a voltage generated between the positive terminal and negative terminal of the electricity storage device 101. The voltage detecting unit 104 includes a voltage amplifying circuit and the like.

The current detecting unit 103 and voltage detecting unit 104 include for example, a digital-analog converting circuit. They perform digital-analog conversion on a detected signal according to a control signal from the internal impedance calculating unit 105, and outputs, to the internal impedance calculating unit 105, data of the detected signal that has been converted to a digital value.

The internal impedance calculating unit 105 calculates the internal impedance of the electricity storage device 101 on the basis of the detection results of the current and voltage at the electricity storage device 101, the detection result having been obtained from the current detecting unit 103 and voltage detecting unit 104.

The internal impedance calculating unit 105 is structured by including, for example, a computer that performs processing in response to instruction codes in a program. The computer includes, for example, a microprocessor, a work memory, and a storage unit (such as a hard disk or an SSD). According to a program, the computer performs control of the current detecting unit 103 and voltage detecting unit 104 and also performs data processing on the detection results of current and voltage.

Specifically, the internal impedance calculating unit 105 controls the alternating-current signal source 102 so that it generates an alternating-current signal at a predetermined frequency fe at which the internal impedance of the electricity storage device 101 or the real part of the internal impedance does not change with temperature, and obtains, from the current detecting unit 103 and voltage detecting unit 104, the detection results of the voltage and current at the electricity storage device 101 to which the alternating-current signal has been supplied. The internal impedance calculating unit 105 analyzes the amplitude and phase of a component of the frequency fe in the detection result of the voltage and current. On the basis of the analysis result, the internal impedance calculating unit 105 calculates a complex number Z that represents the internal impedance of the electricity storage device 101 as a phasor and also calculates the size (norm) |Z| of the complex number Z.

In this description, there may be a case in which the norm |Z| of the complex number Z that represents an internal impedance as a phasor is simply denoted as the internal impedance or internal impedance |Z|. In addition, there may be a case in which the real part R of the complex number Z that represents an internal impedance as a phasor is denoted as the real part of the internal impedance or real part R.

The state inferring unit 106 infers the SOC or SOH of the electricity storage device 101 on the basis of the internal impedance |Z| or real part R of the electricity storage device 101, the internal impedance |Z| or real part R having been calculated in the internal impedance calculating unit 105.

The state inferring unit 106 is structured by including, for example, a computer that performs processing in response to instruction codes in a program. The computer includes, for example, a microprocessor, a work memory, and a storage unit (such as a hard disk or an SSD). The computer infers the SOC or SOH by processing data on the internal impedance |Z| or real part R obtained from the internal impedance calculating unit 105 according to a program. The internal impedance calculating unit 105 and state inferring unit 106 may be formed by using the same computer.

The SOC (state of charge) inferred in the state inferring unit 106 is an index that represents a remaining amount in the electricity storage device 101. For example, the SOC is calculated as a ratio (%) of the amount of stored electricity at the time of inference to the amount of stored electricity at a fully charged time. The SOH (state of health) inferred in the state inferring unit 106 is an index that represents a degree of the deterioration of the electricity storage device 101. For example, the SOH is calculated as a ratio (%) of the amount of stored electricity in a fully charged state at the time of inference to the amount of stored electricity at a time when an unused electricity storage device 101 (new product) is fully charged.

The state inferring unit 106 infers the SOC by, for example, referencing a data table prepared in advance. That is, the state inferring unit 106 prestores a data table of the internal impedance |Z| and SOC or a data table of the real part R and SOC in a storage device, the data table being created by performing measurements or simulations under various conditions. After the internal impedance |Z| or real part R has been calculated in the internal impedance calculating unit 105, the state inferring unit 106 infers the SOC corresponding to the calculation result of the internal impedance |Z| or real part R on the basis of the data table stored in the storage device.

Incidentally, the state inferring unit 106 may store a plurality of data tables in correspondence to deterioration states (SOHs). In this case, the state inferring unit 106 selects an appropriate data table from the plurality of data tables on the basis of an SOH inference result, which will be described later, and infers the SOC on the basis of the selected data table.

The state inferring unit 106 infers the SOH on the basis of the internal impedance |Z| or real part R calculated by the internal impedance calculating unit 105 in, for example, a certain charged state (such as a fully charged state). Specifically, the state inferring unit 106 prestores, in a storage device, a data table of the internal impedance |Z| and SOH in the fully charged state or a data table of the real R and SOH in the fully charged state, the data table being created in advance through an actual measurement or simulation. After the internal impedance |Z| or real part R in the fully charged state has been calculated in the internal impedance calculating unit 105, the state inferring unit 106 infers the SOH corresponding to the calculation result of the internal impedance |Z| or real part R in the fully charged state on the basis of the data table stored in the storage device.

The state inferring unit 106 may determine whether the electricity storage device 101 has reached a predetermined deterioration state on a basis of the reference value of the internal impedance |Z| or real part R in a certain charged state (such as the fully charged state), the reference value having been obtained in advance through a measurement or simulation under a condition in which there is almost no deterioration (at the time of non-use), and a calculated value of the internal impedance |Z| or real part R in the internal impedance calculating unit 105. For example, the state inferring unit 106 calculates a ratio or difference between the reference value described above, which has been prestored in the storage device, and the calculated value of the internal impedance calculating unit 105, compares the calculated ratio or difference with a predetermined threshold, and determines whether the electricity storage device 101 has reached the predetermined deterioration state on the basis of this comparison result.

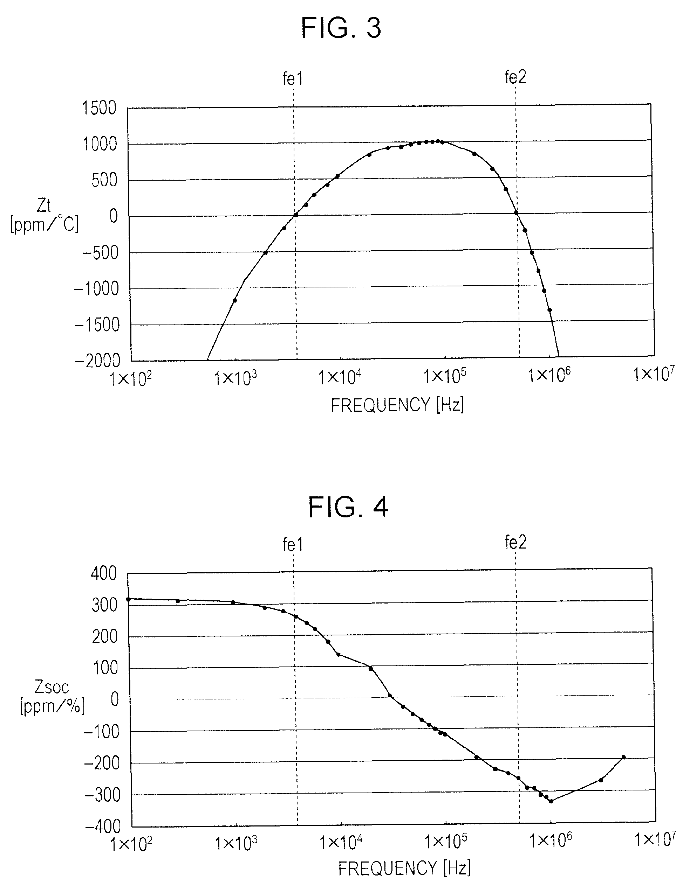

Next, the frequency of the alternating-current signal to be supplied to the electricity storage device 101 for the measurement of the internal impedance |Z| in this embodiment will be described with reference to the graphs in Figs. 3 to 5. The graphs illustrated in Figs. 3 to 5 were obtained by plotting data measured for an 18650-type lithium-ion secondary battery.

Fig. 3 is a drawing that illustrates that the temperature dependency of the internal impedance |Z| of the electricity storage device 101 changes with frequency. The vertical axis in Fig. 3 represents a coefficient Zt [ppm/°C] related to the degree of the change of the internal impedance |Z| with temperature (the coefficient will be denoted below as the temperature coefficient Zt), and the horizontal axis represents frequency [Hz]. According to the graph in Fig. 3, the temperature coefficient Zt has negative dependency in a frequency band lower than frequency fe1 (about 4 kHz), the dependency changes from negative to positive around frequency fe1, the temperature coefficient Zt has positive dependency in a frequency band from frequency fe1 (about 4 kHz) to frequency fe2 (about 500 kHz), the dependency returns from positive to negative again around frequency fe2, and the temperature coefficient Zt has negative dependency in a frequency band higher than frequency fe2 (about 500 kHz).

The internal impedance |Z| of the electricity storage device 101 includes a component based on the participation of ions in electric conduction (the component will be referred to below as the ion conducting component) and a component based on the participation of free electrons in a metal or the like to electric conduction (the component will be referred to below as the electron conducting component). In general, the mobility of ions tends to increase (the resistance tends to be reduced) as the temperature rises, so the ion conducting component is reduced as the temperature rises. On the other hand, free electrons in a metal or the like are likely to undergo scattering and their resistance is thereby increased as the temperature rises, so the electron conducting component is increased as the temperature rises.

Since the ion conducting component is dominant to the electron conducting component in the frequency band lower than frequency fe1 (about 4 kHz), the temperature coefficient Zt of the internal impedance |Z| has negative dependency that is reduced as the temperature rises. When the frequency of the alternating-current signal is increased, ions cannot follow a change of the alternating-current signal and the contribution of the ion conducting component in the internal impedance |Z| is reduced. When the frequency of the alternating-current signal becomes higher than frequency fe1 (about 4 kHz), the electron conducting component is dominant to the ion conducting component, so the temperature coefficient Zt of the internal impedance |Z| has positive dependency.

When the frequency of the alternating-current signal is further increased, the contribution of the ion conducting component in the internal impedance |Z| becomes large again. When the frequency of the alternating-current signal becomes higher than frequency fe2 (about 500 kHz), the ion conducting component is dominant again to the electron conducting component. In a high frequency band, the temperature coefficient Zt of the internal impedance |Z| returns to negative dependency.

As described above, since the ratio of the contribution in the internal impedance |Z| between the ion conducting component and the electron conducting component changes with frequency, the dependency of the temperature coefficient Zt of the electricity storage device 101 changes from positive to negative or from negative to positive. In the present invention, it is noted that the temperature coefficient Zt becomes zero at particular frequencies (fe1, fe2) at which the dependency changes from positive to negative or negative to positive. At frequencies fe1 and fe2, a change of the ion conducting component with temperature and a change of the electron conducting component with temperature are offset by each other and the temperature coefficient Zt thereby becomes zero, so the measured value of the internal impedance |Z| becomes a value independent of the temperature. Therefore, an accurate measurement result independent of the temperature is obtained by setting the frequency of the alternating-current signal of the alternating-current signal source 102 set to these values (fe1, fe2) and measuring the internal impedance |Z| of the electricity storage device 101.

Fig. 4 is a drawing that illustrates that the SOC dependency of the internal impedance of the electricity storage device changes with frequency. The vertical axis in Fig. 4 represents a coefficient Zsoc [ppm/%] related to the degree of the change of the internal impedance |Z| with the SOC (the coefficient will be denoted below as the SOC coefficient Zsoc), and the horizontal axis represents frequency [Hz]. According to the graph in Fig. 4, the absolute value of the SOC coefficient Zsoc is about 250 [ppm/%] around frequencies fe1 (about 4 kHz) and fe2 (about 500 kHz) at which the temperature coefficient Zt of the internal impedance |Z| becomes zero. That is, the internal impedance |Z| measured at frequencies fe1 and fe2 sufficiently greatly changes with the SOC. This indicates that the SOC can be inferred on the basis of the measured values of the internal impedance |Z| that have been obtained at these frequencies.

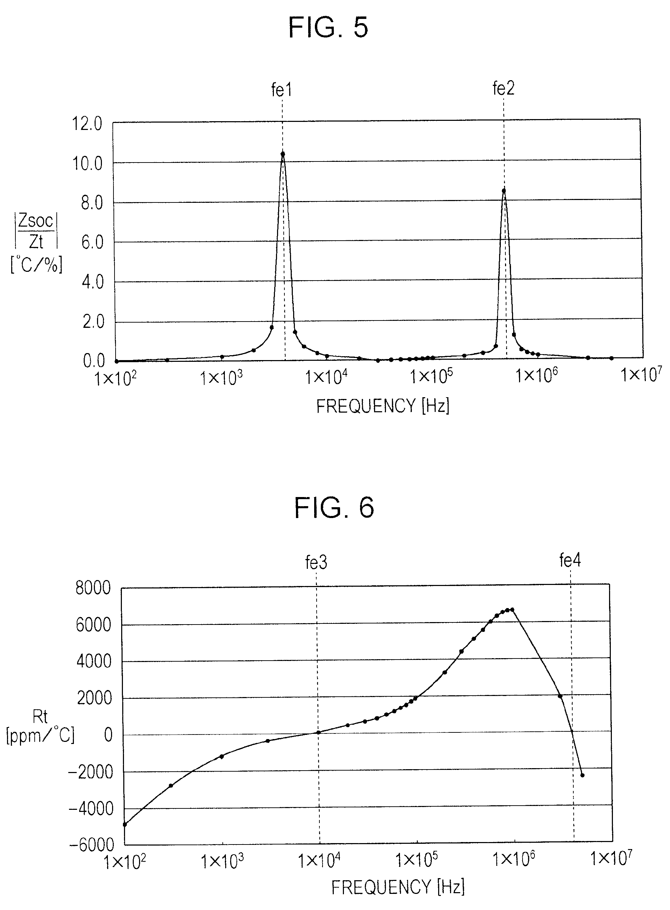

Fig. 5 is a drawing that illustrates a ratio between the SOC dependency illustrated in Fig. 4 and the temperature dependency illustrated in Fig. 3. The vertical axis in Fig. 5 represents the absolute value (|Zsoc/Zt|) of a ratio between the SOC coefficient Zsoc and the temperature coefficient Zt, and the horizontal axis represents frequency. According to the graph in Fig. 5, it is found that the absolute value (|Zsoc/Zt|) of the ratio indicates high values like a peak around frequencies fe1 (about 4 kHz) and fe2 (about 500 kHz). This is because the temperature coefficient Zt becomes zero at frequencies fe1 and fe2 and the SOC coefficient Zsoc keeps a positive or negative value. From this graph, it is found that the internal impedance |Z| that has SOC dependency in a state in which the influence of temperature dependency is small can be measured around frequencies fe1 and fe.

Next, the frequency of the alternating-current signal to be supplied to the electricity storage device 101 for the measurement of the real part R in this embodiment will be described with reference to the graphs in Figs. 6 to 8. The graphs illustrated in Figs. 6 to 8 were obtained by plotting data measured for an 18650-type lithium-ion secondary battery, as in Figs. 3 to 5.

Fig. 6 is a graph that illustrates that the temperature dependency of the real part R of the internal impedance of the electricity storage device 101 changes with frequency. The vertical axis in Fig. 6 represents a coefficient Rt [ppm/°C] related to the degree of the change of the real part R with temperature (the coefficient will be denoted below as the temperature coefficient Rt), and the horizontal axis represents frequency [Hz]. According to the graph in Fig. 6, the temperature coefficient Rt has negative dependency in a frequency band lower than frequency fe3 (about 10 kHz), the dependency changes from negative to positive around frequency fe3, the temperature coefficient Rt has positive dependency in a frequency band from frequency fe3 (about 10 kHz) to frequency fe4 (about 4 MHz), the dependency returns from positive to negative again around frequency fe4, and the temperature coefficient Rt has negative dependency in a frequency band higher than frequency fe4 (about 4 MHz).

The real part R of the internal impedance of the electricity storage device 101 also includes an ion conducting component and an electron conducting component as in the internal impedance |Z|.

Since the ion conducting component is dominant to the electron conducting component in the frequency band lower than frequency fe3 (about 10 kHz), the temperature coefficient Rt of the real part R has negative dependency that is reduced as the temperature rises. When the frequency of the alternating-current signal is increased, the contribution of the ion conducting component is gradually reduced. When the frequency of the alternating-current signal exceeds frequency fe3 (about 10 kHz), the electron conducting component is dominant to the ion conducting component. Therefore, the temperature coefficient Rt of the real part R has positive dependency.

When the frequency of the alternating-current signal is further increased, the contribution of the ion conducting component to the real part R becomes large again. When the frequency of the alternating-current signal becomes higher than frequency fe4 (about 4 MHz), the ion conducting component is dominant again to the electron conducting component. In a high frequency band, the temperature coefficient Rt of the real part R returns to negative dependency.

At frequencies fe3 and fe4 at which the temperature coefficient Rt becomes zero, a change of the ion conducting component with temperature and a change of the electron conducting component with temperature are offset by each other and the temperature coefficient Rt thereby becomes zero, so the measured value of the real part R becomes a value independent of the temperature. Therefore, if the real part R of the internal resistance of the electricity storage device 101 is measured with the frequency of the alternating-current signal of the alternating-current signal source 102 set to one of these values (fe3, fe4), an accurate measurement result independent of the temperature is obtained.

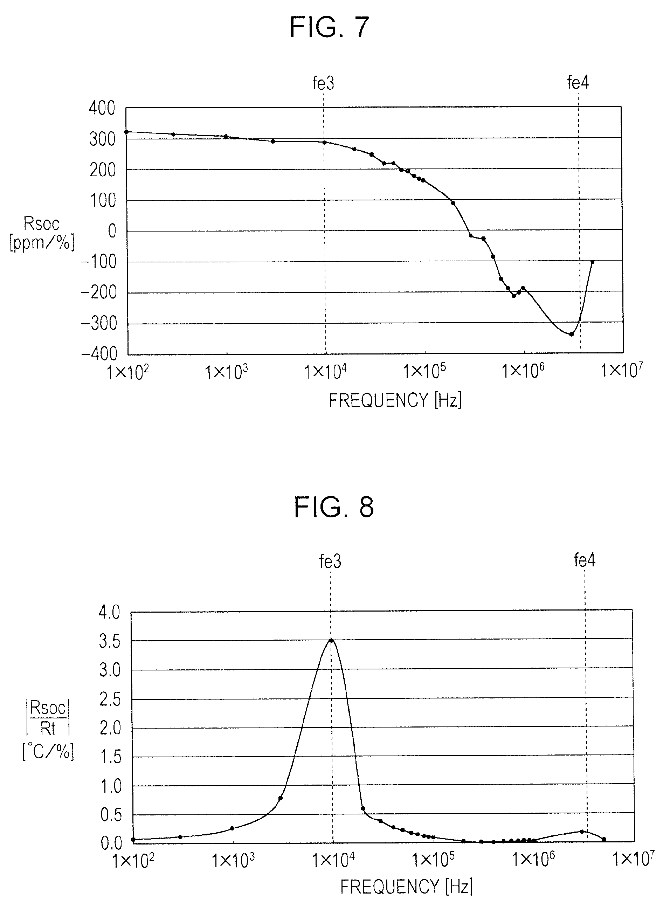

Fig. 7 is a drawing that illustrates that the SOC dependency of the real part R of the internal impedance of the electricity storage device 101 changes with frequency. The vertical axis in Fig. 7 represents a coefficient Rsoc [ppm/%] related to the degree of the change of the real part R with the SOC (the coefficient will be denoted below as the SOC coefficient Rsoc), and the horizontal axis represents frequency [Hz]. According to the graph in Fig. 7, the absolute value of the SOC coefficient Rsoc is about 250 to 300 [ppm/%] around frequencies fe3 (about 10 kHz) and fe4 (about 4 MHz) at which the temperature coefficient Rt of the real part R becomes zero. That is, the real part R of the internal resistance measured at frequencies fe3 and fe4 sufficiently greatly changes with the SOC. This indicates that the SOC can be inferred on the basis of the measured values of the real part R that have been obtained at these frequencies.

Fig. 8 is a drawing that illustrates a ratio between the SOC dependency illustrated in Fig. 7 and the temperature dependency illustrated in Fig. 6. The vertical axis in Fig. 8 represents the absolute value (|Rsoc/Rt|) of a ratio between the SOC coefficient Rsoc and the temperature coefficient Rt, and the horizontal axis represents frequency. According to the graph in Fig. 8, it is found that the absolute value (|Zsoc/Zt|) of the ratio indicates a high value like a peak around frequency fe3 (about 10 kHz). This is because the temperature coefficient Rt becomes zero at frequency fe3 and the SOC coefficient Rsoc keeps a positive or negative value. From this graph, it is found that the real part R that has SOC dependency in a state in which the influence of temperature dependency is small can be measured around frequency fe3.

On the other hand, the ratio (|Zsoc/Z|) around frequency fe4 (about 4 MHz) at which the temperature coefficient Rt becomes zero only indicates a small peak when compared with frequency fe3. This indicates that since the rate of the change of the temperature coefficient Rt and the rate of the change of SOC coefficient Rsoc are very large (changes of the temperature coefficient Rt and SOC coefficient Rsoc are abrupt) around frequency fe4 when compared with the vicinity of frequency fe3, due to an influence such as measurement error or variations in frequency characteristics, there may be a case in which a real part R having sufficient SOC dependency cannot be measured around frequency fe4.

In this case, therefore, it is desirable to perform the measurement of the real part R of the internal impedance at frequency fe3.

In a case in which there are a plurality of frequencies fe at which the temperature coefficient Rt becomes zero as described above, the rate of the change of the SOC coefficient Rsoc with frequency or the rate of the change of the temperature coefficient Rt with frequency may be compared and the measurement of the real part R may be performed at the frequency fe at which the rate of the change is smallest (the change with frequency is gradual). This is because if the rates of the changes of these coefficients (Rsoc, Rt) with frequency are large, there is the possibility that due to small measurement error, individual-depending variations in frequency characteristics, or the like, the real part R having sufficient SOC dependency cannot be measured. This possibility is reduced by selecting a frequency fe at which the frequency-depending change rate of the coefficient (Rsoc, Rt) is small, so the inference precision of the SOC or SOH is improved.

This is also true for a case in which there are a plurality of frequencies fe at which the temperature coefficient Zt becomes zero. The inference precision of the SOC or SOH can be improved by performing the measurement of the internal impedance |Z| at the frequency fe at which the frequency-depending change rate of the SOC coefficient Zsoc or the frequency-depending change rate of the temperature coefficient Zt is smallest.

As described above, according to the electricity storage device state inference method in this embodiment, the internal impedance |Z| of the electricity storage device 10 is measured at a frequency at which the internal impedance of the electricity storage device 101 does not change with temperature, and the SOC or SOH of the electricity storage device 101 is inferred on the basis of the measured value. Furthermore, according to the electricity storage device state inference method in this embodiment, the real part R of the internal impedance of the electricity storage device 10 is measured at a frequency at which the real part R of the internal impedance of the electricity storage device 101 does not change with temperature, and the SOC or SOH of the electricity storage device 101 is inferred on the basis of the measured value.

Thus, since the accurate internal impedance |Z| or real part R that does not depend on the temperature of the electricity storage device 101 can be obtained, a process to measure the temperature of the electricity storage device 101 and correct the measured value of the internal impedance |Z| or real part R becomes unnecessary, making it possible to simplify the measurement procedure and system structure. In addition, the temperature of the electricity storage device 101, the temperature being likely to cause measurement error, does not need to be used in the inference of the SOC or SOH, so inference precision can be increased.

According to the electricity storage device state inference method in this embodiment, in a case in which there are a plurality of frequencies at which the internal impedance |Z| does not change with temperature or in a case in which there are a plurality of frequencies at which the real part R does not change with temperature, the internal impedance |Z| or real part R is measured at the frequency at which the frequency-depending change rate of the amount of change (Zt, Rt) of the internal impedance |Z| or real part R of a target under measurement with temperature is smallest among of the plurality of frequencies or at the frequency at which the frequency-depending change rate of the amount of change (Zsoc, Rsoc) of the internal impedance |Z| or real part R of the target under measurement with the SOC is smallest among of the plurality of frequencies.

Thus, it is possible to reduce the possibility that due to the influence of small measurement error or individual-depending variations in frequency characteristics, the internal impedance |Z| or real part R having sufficient SOC dependency cannot be measured, so the inference precision of the SOC or SOH can be increased.

### <Second embodiment>

Next, a second embodiment of the present invention will be described.

In the electricity storage device state inference method in the first embodiment described above, in a case in which there are a plurality of frequencies at which the internal impedance |Z| does not change with temperature or in a case in which there are a plurality of frequencies at which the real part R does not change with temperature, one preferable frequency is selected from the plurality of frequencies and the inference of a state of the electricity storage device 101 is performed at that frequency. By contrast, in the electricity storage device state inference method in this embodiment, one inference result is obtained by averaging a plurality of inference results obtained at the plurality of frequencies.

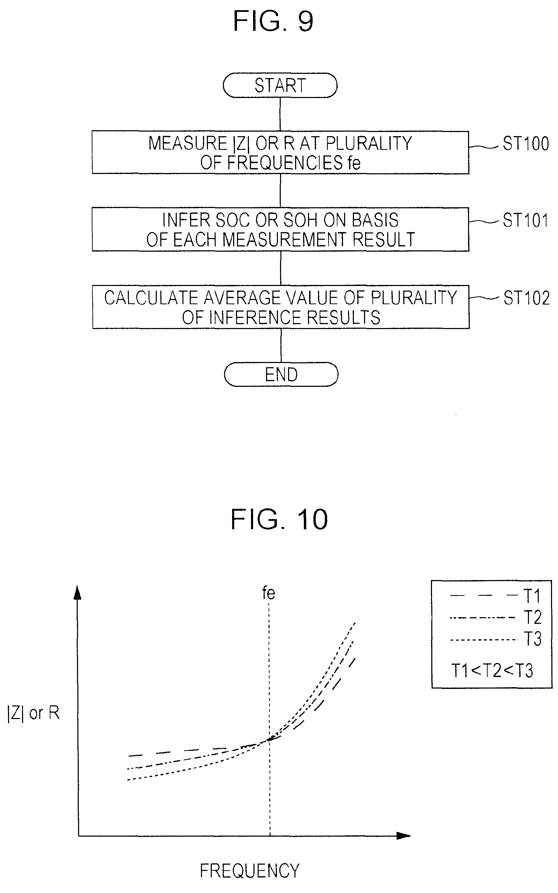

Fig. 9 is a drawing that illustrates an example of a procedure for obtaining an inferred value in an electricity storage device state inference system according the second embodiment of the present invention. The electricity storage device state inference system according to this embodiment has a structure similar to the structure in Fig. 1.

In a case in which there are a plurality of frequencies at which the internal impedance |Z| does not change with temperature or in a case in which there are a plurality of frequencies at which the real part R does not change with temperature, the measurement of the internal impedance |Z| or real part R is performed at each of these frequencies (ST100). That is, an alternating-current signal at each frequency is output from the alternating-current signal source 102, and the internal impedance |Z| or real part R at each frequency is calculated in the internal impedance calculating unit 105.

Next, the inference of the SOC or SOH is performed on the basis of the measured value of the internal impedance | Z| or real part R at the plurality of frequencies (ST101). That is, the SOC or SOH is inferred at each frequency by the state inferring unit 106 on the basis of the calculation result of the internal impedance |Z| or real part R at each frequency in the internal impedance calculating unit 105.

Then, the average value of the SOC or SOH is calculated from the inferred results of the SOC or SOH at each frequency. Calculation of this average value is performed in, for example, the state inferring unit 106.

As described above, according to the electricity storage device state inference method in this embodiment according to this embodiment, a plurality of inference results of an electricity storage device state (SOC, SOH) are obtained on the basis of a plurality of measured values of the internal impedance |Z| or real part R, and one inference result is obtained by averaging the plurality of inference results. Thus, it is possible to reduce the possibility that due to an influence such as measurement error or individual-depending variations in frequency characteristics, large error occurs in the inference result.

### <Third embodiment>

Next, a third embodiment of the present invention will be described.

In each embodiment described above, the frequency fe at which the internal impedance |Z| or real part R does not change with temperature has been obtained in advance through an actual measurement, simulation, or the like. In a case in which an individual state inference is performed, the measurement of the internal impedance |Z| or real part R is performed at a fixed frequency fe stored in a storage device or the like. Therefore, if frequency characteristics vary for each electricity storage devices 101, temperature dependency appears at the frequency fe stored in the storage device or the like, so there is the possibility that error occurs in state inference. By contrast, in the electricity storage device state inference method according to this embodiment, an appropriate frequency fe is obtained for each electricity storage device 101 by a simple method in which the temperature of the electricity storage device 101 is not measured, so state inference error due to the influence of variations among individual electricity storage devices 101 is reduced.

Fig. 10 is a drawing that illustrates that the frequency characteristics of the internal impedance |Z| or real part R of the electricity storage device 101 change with temperature. The vertical axis in Fig. 10 represents the internal impedance |Z| or real part R and the horizontal axis represents frequency. A plurality of graphs illustrated in Fig. 10 indicate the frequency response characteristics of the internal impedance |Z| or real part R at different temperatures (T1 to T3).

As illustrated in, for example, Fig. 10, the frequency response characteristics of the internal impedance |Z| or real part R of the electricity storage device 101 entirely change with the temperature of the electricity storage device 101. At a specific frequency fe, however, the value of the internal impedance |Z| or real part R is fixed regardless of temperature. This frequency fe is equivalent to frequencies fe1 and fe2 in Figs. 3 to 5 and frequencies fe3 and fe4 in Figs. 6 to 8. In this embodiment, therefore, a frequency at which the value of the internal impedance |Z| or real part R is fixed regardless of temperature is obtained by repeatedly measuring the frequency response characteristics of the internal impedance |Z| or real part R within a period during which the temperature of the electricity storage device 101 changes and finding the intersection of the plurality of frequency response curves.

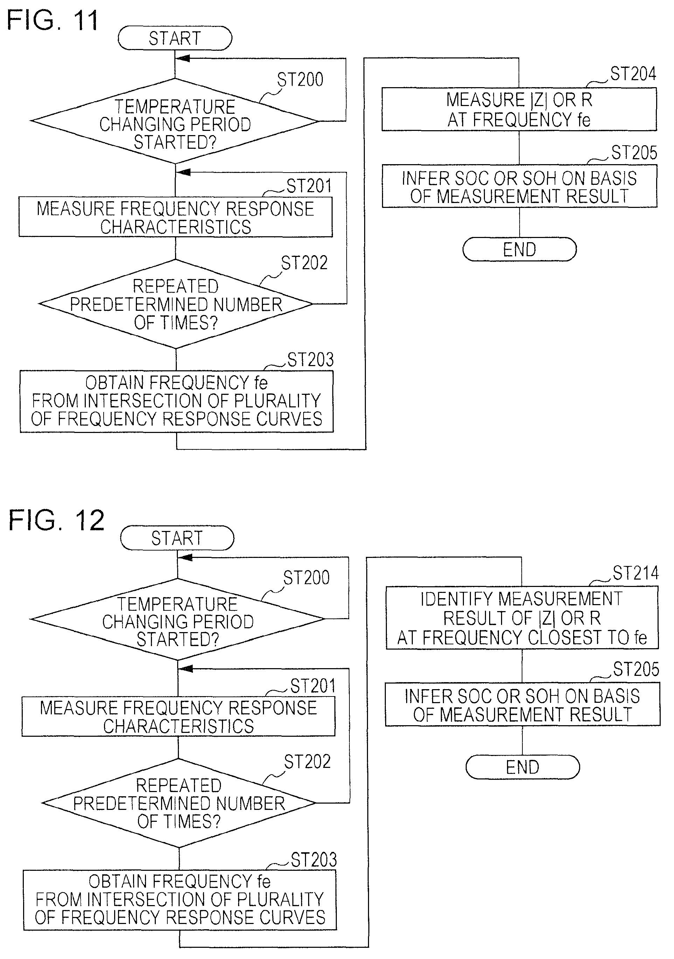

Fig. 11 is a drawing that illustrates an example of a procedure for obtaining an inferred value in the electricity storage device state inference system according to the third embodiment of the present invention. The electricity storage device state inference system according to this embodiment has a structure similar to the structure in Fig. 1.

In the internal impedance calculating unit 105, it is monitored whether a predetermined temperature changing period has been started during which the temperature of the electricity storage device 101 changes in a state in which the charging and discharging of the electricity storage device 101 are being stopped (ST200). This temperature changing period is, for example, a period immediately after the charging or discharging of the electricity storage device 101 is terminated due to an automobile's idling stop or the like. The internal impedance calculating unit 105 is notified of the start of the period by, for example, a high-order apparatus, which is not illustrated, such as a host computer.

When the internal impedance calculating unit 105 is notified of the start of the temperature changing period, the frequency response characteristics of the internal impedance |Z| or real part R in a predetermined frequency range is measured in the internal impedance calculating unit 105 (ST201). This predetermined frequency range is set in advance to, for example, a frequency range evaluated as reliably including a frequency fe through an actual measurement, simulation, or the like.

For example, in the internal impedance calculating unit 105, the alternating-current signal source 102 is controlled so that the frequency of an alternating current to be supplied to the electricity storage device 101 changes from a low frequency side to a high frequency side in the above predetermined frequency range or from the high frequency side to the low frequency side, and the current detecting unit 103 and voltage detecting unit 104 are controlled so that each of the detected values of current and voltage is obtained at a plurality of frequencies included in this predetermined frequency range. On the basis of the detected values of current and voltage, which have been obtained at the plurality of frequencies included in the predetermined frequency range, the measurement result of the internal impedance |Z| or real part R at each of the plurality of frequencies is calculated by the internal impedance calculating unit 105. This frequency response characteristics measurement is repeated a predetermined number of times at time intervals predetermined in the internal impedance calculating unit 105 (ST202).

After a plurality of measurement results of the frequency response characteristics have been obtained, a frequency corresponding to the intersection of a plurality of frequency response curves (see Fig. 10) indicated by the plurality of measurement results is obtained by the internal impedance calculating unit 105 as the frequency fe at which the internal impedance |Z| or real part R does not change with temperature (ST203). For example, on the basis of the measured data of the frequency response characteristics, the frequency response curves are approximated to predetermined functions (such as polynomials) by the least squares method or the like. A point at which the approximate functions of the frequency response curves intersect is calculated by performing an operation of a formula for a solution or a numerical analysis operation. In a case in which a plurality of intersections are calculated, the frequency fe is calculated by averaging the plurality of intersections. After the frequency fe has been obtained, the internal impedance |Z| or real part R at the frequency fe is measured by the internal impedance calculating unit 105 (ST204). In the state inferring unit 106, the SOC or SOH of the electricity storage device 101 is inferred on the basis of the internal impedance |Z| or real part R measured by the internal impedance calculating unit 105 at the frequency fe.

As described above, in the electricity storage device state inference method in this embodiment, the frequency response characteristics of the internal impedance |Z| or real part R in a predetermined frequency range is repeatedly measured a plurality of times in a predetermined temperature changing period during which the temperature of the electricity storage device 101 changes in a state in which the charging and discharging of the electricity storage device 101 are being stopped. A frequency corresponding to the intersection of a plurality of frequency response curves indicated by a plurality of measurement results of the frequency response characteristics is obtained as the frequency fe at which the internal impedance |Z| or real part R does not change with temperature.

Thus, even in a case in which the frequency fe varies for each electricity storage devices 101, an appropriate frequency fe can be obtained for each individual. Therefore, when compared with a case in which a fixed frequency fe that does not depend on an individual is used, the state (SOC, SOH) of an individual electricity storage device 101 can be accurately inferred. In addition, implementation is possible by data processing by the internal impedance calculating unit 105, without having to measure the temperature of the electricity storage device 101 to obtain the frequency fe. Therefore, there is the merit that the device structure is not complicated.

Although, in the method indicated by the flowchart in Fig. 11, the measurement of the internal impedance |Z| or real part R is performed by using the frequency fe obtained in step ST203, since the measurement of the internal impedance |Z| or real part R has been already performed in the measurement of the frequency response characteristics in step ST201, it is possible to omit re-measurement in which the frequency fe is used.

Fig. 12 is a drawing that illustrates another example of a procedure for obtaining an inferred value in the electricity storage device state inference system according to the third embodiment of the present invention, illustrating a flow in a case in which re-measurement based on the frequency fe is omitted. The flow illustrated in Fig. 12 is a flow in which step ST204 in the flow illustrated in Fig. 11 is replaced with step ST214. The other steps are the same as in the flow illustrated in Fig. 11.

According to the flow illustrated in Fig. 12, instead of re-measurement being performed by using the frequency fe (ST204), measured values that have been already obtained in step ST201 are searched for a measured value at the frequency closest to the frequency fe, and the searched-for measured value is obtained as a measured value to be used in the inference of the SOC or SOH of the electricity storage device 101 (ST214). This processing is executed in, for example, the internal impedance calculating unit 105.

Thus, since the number of measurements is reduced by omitting re-measurement in which the frequency fe is used, a time taken to infer a state (SOC, SOH) of an electricity storage device can be shortened.

So far, some embodiments of the present invention have been described. However, the present invention is not limited to the embodiments described above. The present invention includes various variations.

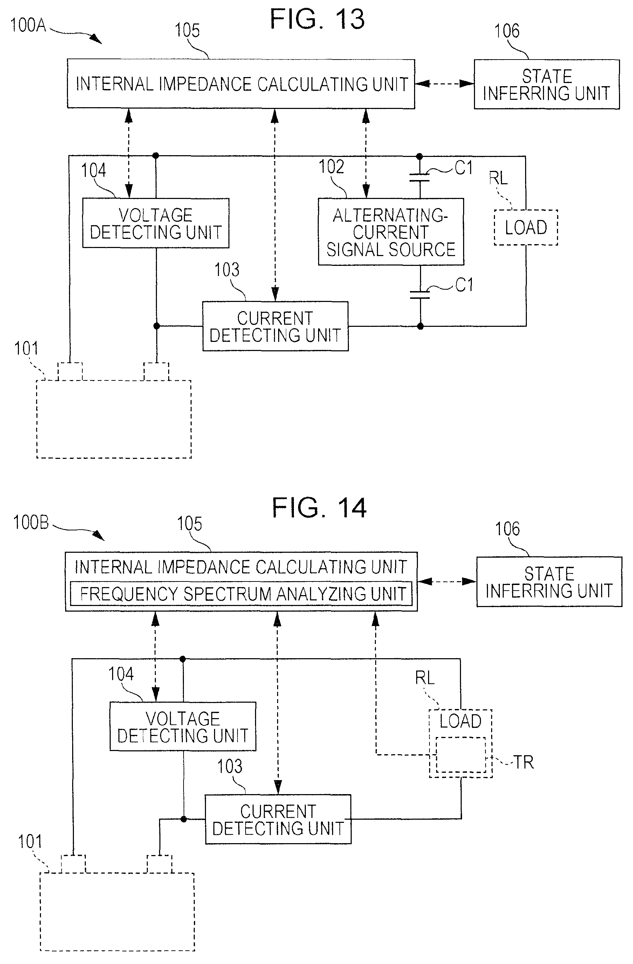

Although, in the electricity storage device state inference system 100 illustrated in Fig. 1, for example, the alternating-current signal source 102 is disposed on a path through which a current flows from the electricity storage device 101 to the load RL, the present invention is not limited to this example. In another embodiment of the present invention, the alternating-current signal source 102 may be connected in parallel to the load RL as in, for example, an electricity storage device state inference system 100A illustrated in Fig. 13. In this case, a capacitor C1 may be provided on at least one signal path that connects the alternating-current signal source 102 and load RL so that a direct current does not flow into the alternating-current signal source 102. According to the electricity storage device state inference system 100A illustrated in Fig. 13, since a large direct current flowing from the electricity storage device 101 to the load RL does not pass through the alternating-current signal source 102, it is possible not only to suppress electric power consumption in the alternating-current signal source 102 but also to prevent a drop in a supplied voltage of the load RL due to a voltage drop caused in the alternating-current signal source 102.

Although, in the electricity storage device state inference system 100 illustrated in Fig. 1, the alternating-current signal source 102 is provided to measure an internal impedance, the present invention is not limited to this example. In another embodiment of the present invention, the alternating-current signal source 102 may be omitted by using a pulse-shaped signal TR generated in the load RL as an alternating current to be supplied to the electricity storage device 101 to eliminate, as in, for example, an electricity storage device state inference system 100B illustrated in Fig. 14.

In the case of an automobile, the pulse-shaped signal TR in the load RL is generated at the start of the engine, at the use of a regenerative brake, at fast charging, or the like. A timing of the generation of the pulse-shaped signal TR is notified by a high-order device, which is not illustrated, to the internal impedance calculating unit 105. A frequency spectrum analyzing unit is provided in the internal impedance calculating unit 105, so when the internal impedance calculating unit 105 is notified of the pulse-shaped signal TR, frequency spectrum analysis is performed on voltage and current detection signals obtained at that timing. The simple internal impedance of the electricity storage device 101 at the frequency fe is calculated on the basis of the spectrum components (voltage and current) of the frequency fe, the spectrum components having been extracted in this analysis.

As described above, according to the electricity storage device state inference system 100B illustrated in Fig. 14, it is possible to eliminate the alternating-current signal source 102, which generates an alternating-current signal at a high frequency, so the device structure can be simplified.

### Reference Signs List

100, 100A, 100B electricity storage device state inference system
   - 101: electricity storage device
   - 102: alternating-current signal source
   - 103: current detecting unit
   - 104: voltage detecting unit
   - 105: internal impedance calculating unit
   - 106: state inferring unit
   - RL: load
   - C1: capacitor

## Claims

1. An electricity storage device state inference method **characterized in that**:
at least one frequency at which an internal impedance of an electricity storage device does not change with temperature, the internal impedance is measured or, at least one frequency at which a real part of the internal temperature does not change with temperature, the real part is measured; and
an SOC (state of charge) or an SOH (state of health) of the electricity storage device is inferred on a basis of a measured value of the internal impedance or a measured value of the real part.

2. The electricity storage device state inference method according to Claim 1, **characterized in that** the frequency at which the internal impedance is measured is a frequency at which a change of a component in the internal impedance, the component being based on ion conduction, with temperature and a change of a component in the internal impedance, the component being based on electron conduction, with temperature are offset by each other.

3. The electricity storage device state inference method according to Claim 1, **characterized in that** the frequency at which the real part is measured is a frequency at which a change of a component in the real part, the component being based on ion conduction, with temperature and a change of a component in the real part, the component being based on electron conduction, with temperature are offset by each other.

4. The electricity storage device state inference method according to any one of Claims 1 to 3, **characterized in that**:
there are a plurality of frequencies at which the internal impedance does not change with temperature or there are a plurality of frequencies at which the real part does not change with temperature; and
the measurement is performed at a frequency at which a frequency-depending change rate of an amount of change of the internal impedance or the real part of a target under measurement with temperature is smallest among the plurality of frequencies or at a frequency at which a frequency-depending change rate of an amount of change of the internal impedance or the real part of the target under measurement with the SOC is smallest among the plurality of frequencies.

5. The electricity storage device state inference method according to any one of Claims 1 to 3, **characterized in that**:
there are a plurality of frequencies at which the internal impedance does not change with temperature or there are a plurality of frequencies at which the real part does not change with temperature;
the measurement of the internal impedance or the real part is performed at the plurality of frequencies;
an inference of the SOC or the SOH is performed on a basis of a measured value of the internal impedance or the real part at the plurality of frequencies; and
an average of a plurality of results of the inference on a basis of the plurality of frequencies is calculated.

6. The electricity storage device state inference method according to any one of Claims 1 to 5, **characterized in that**:
the electricity storage device is a lithium-ion battery; and
the measurement of the internal impedance is performed at a frequency of 4 kHz and/or 500 kHz.

7. The electricity storage device state inference method according to any one of Claims 1 to 5, **characterized in that**:
the electricity storage device is a lithium-ion battery, and
the measurement of the real part is performed at a frequency of 10 kHz and/or 4 MHz.

8. The electricity storage device state inference method according to any one of Claims 1 to 5, **characterized in that**:
frequency response characteristics of the internal impedance or the real part in a predetermined frequency range is repeatedly measured a plurality of times in a predetermined temperature changing period during which a temperature of the electricity storage device changes in a state in which charging and discharging of the electricity storage device are being stopped; and
a frequency corresponding to an intersection of a plurality of frequency response curves indicated by a plurality of measurement results of the frequency response characteristics is obtained as the frequency at which the internal impedance or the real part does not change with temperature.

9. The electricity storage device state inference method according to Claim 8, **characterized in that**, of measured values of the internal impedance or the real part, the measured values being included in measurement results of the frequency characteristics, a measured value at a frequency closest to a frequency corresponding to the intersection is obtained as a measured value to be used in an inference of the SOC or SOH of the electricity storage device.

10. The electricity storage device state inference method according to Claim 8 or 9, **characterized in that** the temperature changing period is a period immediately after charging or discharging of the electricity storage device is terminated.

11. The electricity storage device state inference method according to any one of Claims 8 to 10, **characterized in that** in a measurement of the frequency response characteristics, while a frequency of an alternating-current signal to be supplied to the electricity storage device is changed from low frequency to high frequency or from high frequency to low frequency in the predetermined frequency range, the internal impedance or the real part is measured at a plurality of frequencies included in the frequency range.
